# EUROPEAN PATENT SPECIFICATION

(11) **EP 4 012 853 B1**
(45) Date of publication and mention of the grant of the patent: **26.07.2023**
(21) Application number: 20212917.7
(22) Date of filing: 09.12.2020
(51) Int. Cl.: H01S 5/02212, H01S 5/02253, H01S 5/02255, H01S 5/40, H01S 5/00

(54) **SEMICONDUCTOR PACKAGE, ASSEMBLY, AND APPARATUS**
HALBLEITEREINHEIT, BAUGRUPPE UND VORRICHTUNG
BOÎTIER SEMI-CONDUCTEUR, ASSEMBLAGE ET DISPOSITIF

(43) Date of publication of application: 15.06.2022
(73) Proprietor: Laserworld (Switzerland) AG, 8574 Lengwil (CH)
(72) Inventor: Luque, Jordi, 83626 Valley (DE)
(74) Representative: Meyer zu Bexten, Elmar

(56) References cited:
- WO-A1-2015/191818
- US-A1- 2008 019 010
- US-A1- 2008 063 017
- US-A1- 2014 240 952
- US-A1- 2016 195 236
- US-A1- 2017 040 768
- US-B1- 9 413 136
- US-B2- 10 283 939

## Description

### Technical Field

The invention relates to the products as per the first portion of independent claim 1.

### Background Art

By laser diode (LD), injection laser diode (ILD), or diode laser is meant any semiconductor device in which a light-emitting diode pumped directly with electrical current creates lasing conditions at its junction. NPL1 provides a comprehensive treatment of these and other photonic integrated circuits.

For instance, the state of the art comprises laser diodes in can-type housing with an optical axis along or parallel to their symmetry axis. PTL1 discloses one such diode.

US2014/240952 A1 discloses red, green and blue laser diodes, LDs, within a single 5.6mm base diameter TO-CAN package, wherein light emitted from the LDs is collimated by respective ball-shaped collimating lenses adhered within the package.

### Summary of invention

The invention as claimed is hereinafter disclosed in such a way that the technical problem with which it deals can be appreciated and the solution can be understood.

### Technical Problem

The problem is to seek an alternative to the known device which provides the same or similar effects or is more cost-effective.

### Solution to Problem

The problem is solved as per the second portion of Claim 1.

### Advantageous effect of invention

The emitted laser beam is shaped near its emission point which significantly narrows emission angle for the fast axis.

Additional collimation lenses are employed to adjust the diameter and divergence of the laser beam.

By arranging multiple such beams into a combined beam, total laser power can be greatly increased.

### Brief description of drawings

Figure 1 is a top view of a semiconductor package.
Figure 2 is a side view of the package.
Figure 3 is a top view of a first assembly.
Figure 4 is a side view of a second assembly.
Figure 5 is a top view of a first apparatus.
Figure 6 is a top view of a second apparatus.

### Description of embodiments

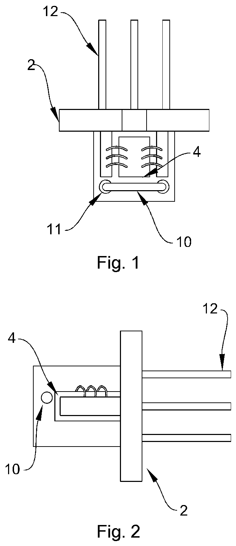

Figure 1 and Figure 2 show a metallic semiconductor package having a transistor outline, as is known in the art as a TO can. The package contains a multi-mode laser diode (2) for emitting a visible laser beam at an emission point (4) within the package. As with a conventional TO package, three connection pins (12) protrude from the diode (2), facing away from the emission point (4). Near that point (4), an optical fiber (10) is retained within the package by means of adhesive (11), the fiber (10) acting as a cylindrical microlens configured for fast-axis correction (FAC) of the emitted laser beam.

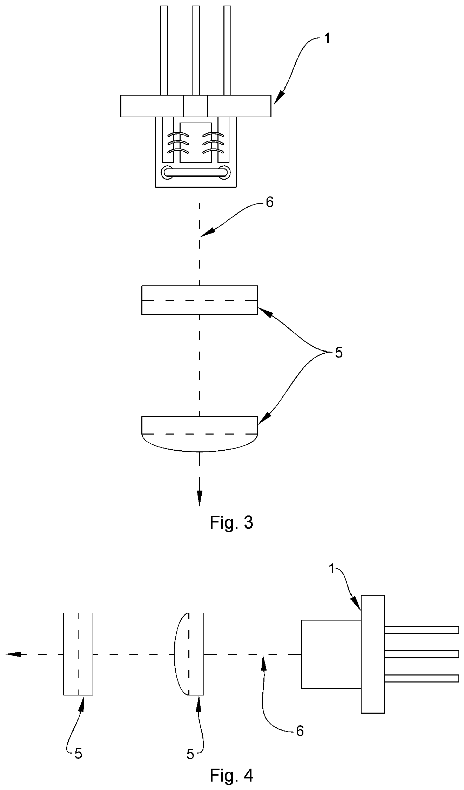

Figure 3 and Figure 4 each show an assembly comprising, in addition to such package (1), two coaxial cylindrical lenses (5) acting as collimation lenses (5) arranged on the optical axis (6) of the microlens.

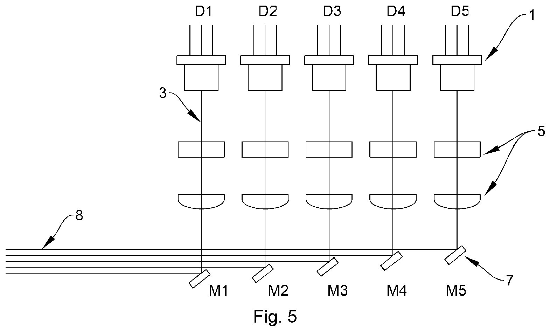

Figure 5 shows an apparatus comprising five assemblies as per Figure 3. Near the bottom of the drawing, five mirrors (7) combine the five resulting laser beams (3) into a single collimated beam (8).

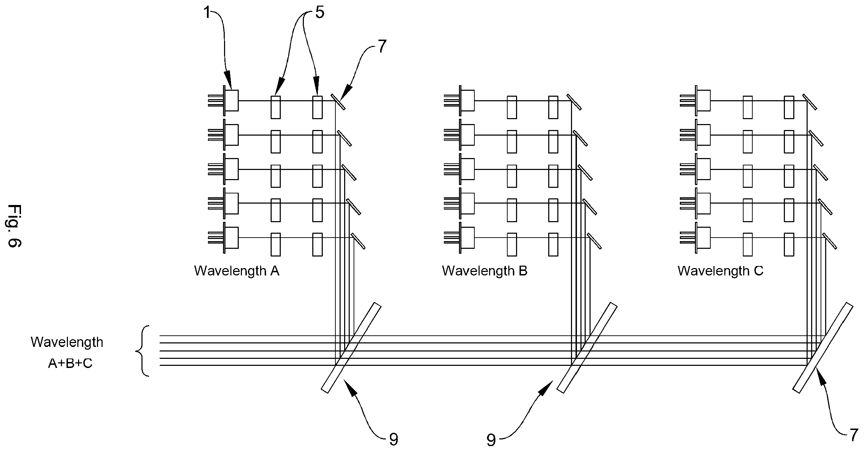

Finally, Figure 6 shows a further apparatus comprising fifteen packages (1) whose diodes (2) operate at three different wavelengths. Accordingly, the packages (1) are collocated in three groups of five diodes (2) each. Fifteen mirrors (7) are arranged opposite the diodes (2) such that, for each wavelength, the laser beams originating from the respective group are spatially multiplexed into a monochromatic beam. Another mirror (7) and two dichroic mirrors (9), each allocated to one among the groups and configured to reflect only the corresponding wavelength, further combine these monochromatic beams by spectral multiplexing technique into a collimated beam (8) whose spectrum is composed of all three wavelengths.

### Industrial applicability

The invention is applicable, inter alia, throughout the electronics and entertainment industries.

### Reference signs list

- 1: Semiconductor package
- 2: Laser diode
- 3: Laser beam
- 4: Emission point
- 5: Collimation lens
- 6: Optical axis
- 7: Mirror
- 8: Collimated beam
- 9: Dichroic mirror
- 10: Optical fiber
- 11: Adhesive
- 12: Connection pin

### Citation list

The following documents are cited hereinbefore.

### Patent literature

PTL1: US 10690321 B (OSRAM GMBH [DE]) 21.11.2019

### Non-patent literature

NPL1: COLDREN, Larry A., et al. Diode lasers and photonic integrated circuits. 2nd edition. Hoboken, New Jersey: John Wiley & Sons, 2012. ISBN 0470484128.

## Claims

1. Assembly comprising a semiconductor package (1) containing a laser diode (2) for emitting a laser beam (3) at an emission point (4) within the package (1), wherein
the package (1) is metallic, has a transistor outline between 5.6 and 9 mm in base diameter, and
the laser beam (3) is visible, **characterised in that** the metallic transistor outline package (1) contains an optical fiber (10) acting as a microlens attached nearby the emission point (4) and retained within the transistor outline package (1) by means of an adhesive, and
the assembly further comprises two coaxial cylindrical collimation lenses (5) arranged outside the transistor outline package (1) on an optical axis (6) of the microlens.

2. Apparatus comprising
multiple assemblies as per Claim 1 and
a corresponding number of mirrors (7) for combining the laser beams (3) into a collimated beam (8).

3. Apparatus as per Claim 2, further comprising dichroic narrow band mirrors (9) for further combining the laser beams (3).

4. Apparatus as per Claim 3
wherein
the diodes (2) are configured to operate at different wavelengths,
the mirrors (7) are arranged vis-à-vis the diodes (2) such that, for each among the wavelengths, the laser beams (3) are spatially multiplexed into a combined monochromatic beam, and
the dichroic mirrors (9) are arranged and each configured to reflect one among the wavelengths such that the collimated beam (8) exhibits a spectrum composed of said wavelengths.

5. Apparatus as per Claim 4
wherein
the packages (1) are collocated in groups according to the wavelengths of their diodes (2) and
each among the dichroic mirrors (9) is allocated to one among the groups.

6. Apparatus as per any of the preceding claims
wherein
the or each package (1) bears connection pins (12) protruding from the diode (2)

7. Apparatus as per Claim 6
wherein
the pins (12) face away from the emission point (4).

8. Apparatus as per any of the preceding claims
wherein
the microlens acts as a cylindrical microlens.

9. Apparatus as per any of the preceding claims
wherein
the microlens is arranged for fast-axis correction of the laser beam (3).

10. Apparatus as per any of the preceding claims
wherein
the diode (2) is a multi-mode laser diode (2).

## Patentansprüche

1. Baugruppe mit einem Halbleitergehäuse (1), das
eine Laserdiode (2) zur Aussendung eines Laserstrahls (3) an einem Aussendepunkt (4) im Gehäuse (1) beinhaltet,
wobei
das Gehäuse (1) aus Metall ist, einen Transistor-Umriss zwischen 5,6 und 9 mm Basisdurchmesser aufweist und
der Laserstrahl (3) sichtbar ist,
**dadurch gekennzeichnet, dass**
das metallische Gehäuse (1) eine als Mikrolinse fungierende optische Faser (10) enthält, die nahe dem Aussendepunkt (4) angebracht und mittels eines Klebstoffs innerhalb des Gehäuses (1) befestigt ist, und
die Anordnung zusätzlich zwei koaxiale zylindrische Kollimationslinsen (5) umfasst, die außerhalb des Gehäuses (1) auf einer optischen Achse (6) der Mikrolinse angeordnet sind.

2. Vorrichtung mit
mehreren Baugruppen gemäß Anspruch 1 und
einer entsprechenden Anzahl von Spiegeln (7) zur Zusammenführung der Laserstrahlen (3) in einen kollimierten Strahl (8).

3. Vorrichtung gemäß Anspruch 2,
ferner umfassend
dichroitische Schmalbandspiegel (9) zur weiteren Zusammenführung der Laserstrahlen (3).

4. Vorrichtung gemäß Anspruch 3,
wobei
die Dioden (2) so konfiguriert sind, dass sie bei unterschiedlichen Wellenlängen arbeiten,
die Spiegel (7) gegenüber den Dioden (2) angeordnet sind, sodass für jede der Wellenlängen die Laserstrahlen (3) räumlich in einen kombinierten monochromatischen Strahl multiplexiert sind, und
die dichroitischen Spiegel (9) so angeordnet und jeweils konfiguriert sind, dass sie eine der Wellenlängen reflektieren, sodass der kollimierte Strahl (8) ein Spektrum aus besagten Wellenlängen aufweist.

5. Vorrichtung gemäß Anspruch 4,
wobei
die Gehäuse (1) entsprechend den Wellenlängen ihrer Dioden (2) in Gruppen zusammengefasst sind und
jeder der dichroitischen Spiegel (9) einer der Gruppen zugeordnet ist.

6. Vorrichtung gemäß einem der vorhergehenden Ansprüche,
wobei
das oder jedes Gehäuse (1) Anschlusspins (12) trägt, die aus der Diode (2) herausragen.

7. Vorrichtung gemäß Anspruch 6,
wobei
die Pins (12) vom Aussendepunkt (4) fort weisen.

8. Vorrichtung gemäß einem der vorhergehenden Ansprüche,
wobei
die Mikrolinse als zylindrische Mikrolinse fungiert.

9. Vorrichtung gemäß einem der vorhergehenden Ansprüche,
wobei
die Mikrolinse zur Korrektur der schnellen Achse des Laserstrahls (3) eingerichtet ist.

10. Vorrichtung gemäß einem der vorhergehenden Ansprüche,
wobei
die Diode (2) eine Multimode-Laserdiode (2) ist.

## Revendications

1. Assemblage comprenant un boîtier semi-conducteur (1) contenant une diode laser (2) pour émettre un faisceau laser (3) à un point d'émission (4) à l'intérieur du boîtier (1), où le boîtier (1) est métallique, a un contour de transistor entre 5,6 et 9 mm de diamètre de base, et le faisceau laser (3) est visible, **caractérisé en ce que** le boîtier de contour de transistor métallique (1) contient une fibre optique (10) agissant comme une microlentille fixée à proximité du point d'émission (4) et maintenue à l'intérieur du boîtier de contour de transistor (1) par un adhésif, et l'assemblage comprend en outre deux lentilles de collimation cylindriques coaxiales (5) disposées à l'extérieur du boîtier de contour de transistor (1) sur un axe optique (6) de la microlentille.

2. Appareil comprenant plusieurs assemblages selon la revendication 1 et un nombre correspondant de miroirs (7) pour combiner les faisceaux lasers (3) en un faisceau collimaté (8).

3. Appareil selon la revendication 2, comprenant en outre des miroirs à bande étroite dichroïque (9) pour combiner encore plus les faisceaux lasers (3).

4. Appareil selon la revendication 3 où les diodes (2) sont configurées pour fonctionner à différentes longueurs d'onde, les miroirs (7) sont disposés vis-à-vis des diodes (2) de telle sorte que, pour chaque longueur d'onde, les faisceaux lasers (3) sont multiplexés spatialement en un faisceau monochromatique combiné, et les miroirs dichroïques (9) sont disposés et chaque miroir est configuré pour refléter une longueur d'onde parmi les longueurs d'onde de telle sorte que le faisceau collimaté (8) présente un spectre composé desdites longueurs d'onde.

5. Appareil selon la revendication 4 où les boîtiers (1) sont regroupés par groupes selon les longueurs d'onde de leurs diodes (2) et chacun des miroirs dichroïques (9) est attribué à l'un des groupes.

6. Appareil selon l'une quelconque des revendications précédentes où chaque boîtier (1) porte des broches de connexion (12) faisant saillie de la diode (2).

7. Appareil selon la revendication 6 où les broches (12) sont orientées à l'opposé du point d'émission (4).

8. Appareil selon l'une quelconque des revendications précédentes où la microlentille agit comme une microlentille cylindrique.

9. Appareil selon l'une quelconque des revendications précédentes où la microlentille est disposée pour la correction de l'axe rapide du faisceau laser (3).

10. Appareil selon l'une quelconque des revendications précédentes où la diode (2) est une diode laser multimode (2).
